# EUROPEAN PATENT APPLICATION

(11) **EP 4 438 557 A1**
(43) Date of publication of application: **02.10.2024**
(21) Application number: 23198641.5
(22) Date of filing: 20.09.2023
(51) Int. Cl.: C01B 33/02, H01M 4/38, H01M 10/0525

(54) **LIGHTLY OXIDIZED SILICON KERF PARTICLES AS ANODE OR ANODE PRECURSOR MATERIAL IN LI-ION BATTERIES**

(30) Priority: 27.03.2023 NO 20230343
(71) Applicant: Resitec AS, 4617 Kristiansand (NO)
(72) Inventor: SØILAND, Anne-Karin, 4623 Kristiansand (NO); CHRISTENSEN HEINTZ, Mads, 4623 Kristiansand (NO); MØRK, Knut, 4623 Kristiansand (NO); VELKEN, Sjur Vidar, 4626 Kristiansand (NO)
(74) Representative: Zacco Norway AS

(57) **Abstract**

The present invention relates to silicon kerf particles with a defined and narrow oxide layer, and a powder of said silicon kerf particles as agglomerates and/or single particles. The invention also provides use of this new silicon kerf particles and powder as anode material or anode precursor material in lithium-ion batteries.

## Description

### Field of the invention

The present invention relates to silicon kerf particles with a defined and narrow oxide layer, a powder of said silicon kerf particles as agglomerates and/or single particles, and use of said silicon kerf particles or said powder as anode material or anode precursor material in lithium-ion batteries.

### Background of the invention

Silicon is considered the next generation anode material for Li-ion batteries (LIBs) mainly due to its high energy storage capacity, which is 10 times higher, compared to conventional graphite materials. This has created a high drive to implement silicon into the anode despite the challenges that exist with regards to stability during cycling. There are battery producers today that integrate a few % of silicon into the anode. The battery industry is expected to convert gradually from graphite to silicon in the years to come.

Different types of commercial silicon for LIBs exist. For obtaining an improved cycling stability of the cell a silicon particle size of around 100 nm is desirable [ref. G. Zhu, Y. Wang, S. Yang, Q. Qu, H. Zheng, "Correlation between physical parameters and the electrochemical performance of a silicon anode in lithium-ion batteries", Journal of Materiomics 5, 2019, pp 164-175]. Chemical vapour deposition, from trichlorosilane or silane gases, is a commonly used method to produce spherical particles of these sizes. For further enhancement of the cycling stability carbon coatings are widely used. These processes are both energy intensive (high temperature) and complex, which results in higher carbon footprints, in addition the silane gases employed are very hazardous. Another method is through wet milling of larger crystalline silicon particles. A suitable liquid medium has to be used due to the explosive nature of fine silicon particles attributed to their high reactivity against oxygen and water, and subsequent drying steps are required. Such type of silicon bears in addition to a significant carbon footprint, a high cost of production. As a consequence of this silicon to LIBs is today traded at a price of 100K - 200K USD/MT.

The photovoltaic (PV) industry is by far the largest consumer of highly pure polysilicon today, with a total consumption of 549 000 tons in 2021 (2.88-3.27 kt/GW) [ref. B. Hallam, M. Kim, R. Underwood, S. Drury, L. Wang, P. Dias, "A polysilicon learning curve and the material requirements for broad electrification with photovoltaics by 2050", Solar RRL 2022, 6]. During the wafering of silicon blocks there is a silicon kerf loss of 30-40%. This means a substantial amount of highly pure silicon is a by-/waste-product from the PV industry. The utilization of this silicon, either back to PV, or to other higher value applications, like LIBs would be clearly beneficial.

From the wafering process, the silicon kerf particles are in a slurry consisting mainly of silicon particles suspended in water with remnants of cutting fluid. This slurry is typically filtered through a filter press at the wafer producer, yielding a filter cake with moisture contents ranging from 30-50 wt%.

Since the silicon kerf contains significant amounts of water it is readily oxidized due to its small size and high specific surface area through the exothermic reaction with water.

Si₍ₛ₎ + H₂O₍₁₎ = SiO₂₍ₛ₎ + H_{2(g)}

Δ Hᵣ⁰= -339 kJ/mol at standard state conditions

Si₍ₛ₎ + H₂O_{(g)} = SiO₂₍ₛ₎ + H_{2(g)}

Δ Hᵣ⁰= -427 kJ/mol at standard state conditions

Furthermore, the reaction rate enhances with temperature and therefore controlling the oxide layer is a particular challenge when heating the silicon kerf material during a drying process, even if kept under inert conditions.

It is particularly beneficial to have controlled oxide layer thickness. A study of oxide layer thicknesses revealed that below 3 nm layer thickness is necessary to not adversely affect the electrochemical performance [ref. M. Schnabel, S.P. Harvey, E. Area, C. Stetson, G. Teeter, C. Ban, P. Stradins, "Surface SiO2 thickness controls uniform-to-localized transition in lithiation of silicon anodes for lithium-ion batteries", ACS Applied Materials Interfaces, 2020, 12, 24, pp 27017 - 27028].

Therefore, there is a desire to provide silicon kerf particles having an oxide layer with a thickness well below 3 nm useful as anode material or anode precursor material in LIBs.

The present inventors have surprisingly been able to provide silicon kerf particles with a defined and narrow oxide layer and a powder of the mentioned silicon kerf particles with a specific and narrow agglomerate size distribution.

On this basis, the present invention has been provided.

### Summary of the invention

It is a main object of the present invention to provide silicon kerf particles with a defined and narrow oxide layer for use as anode material or anode precursor material in lithium-ion batteries.

Another object of the present invention is to provide a powder of the said silicon kerf particles with a defined tap density and agglomerate size also useful as anode material or anode precursor material in lithium-ion batteries.

These and other objects are obtained by subject-matter as defined in the accompanying claims.

### Definitions

It is to be understood that the herein disclosed invention is not limited to the particular component parts of the material described or steps of the methods described since such material and method may vary. It is also to be understood that the terminology used herein is for purpose of describing particular embodiments only and is not intended to be limiting.

It should be noted that, as used in the specification and the appended claim, the articles "a", "an", "the", and "said" are intended to mean that there are one or more of the elements unless the context explicitly dictates otherwise. Thus, for example, reference to "a unit" or "the unit" may include several means, and the like. Furthermore, the words "comprising", "including", "containing" and similar wordings does not exclude other elements or steps.

The terms "lithium-ion batteries", "Li-ion batteries" and "LIBs" as used herein have the same meaning and are used interchangeably in the present disclosure.

The terms "silicon kerf", "kerf", "kerf particles" and "particles" are used interchangeably in the present disclosure for the small silicon particles (chips) formed during the wire cutting of blocks into wafers.

The term "d10" as used herein means that 10 volume % of the particles has a size lower than the obtained d10 value, the term "d50" as used herein means that 50 volume % of the particles has a size lower than the obtained d50 value, and the term "d90" as used herein means that 90 volume % of the particles has a size lower than the obtained d90 value.

The term "powder" as used in the present disclosure means a mixture comprising silicon kerf agglomerates and/or single particles of silicon kerf particles.

The term "tap density" as used herein is the ratio of the mass of the powder to the volume occupied by the powder after it has been tapped for a defined period of time.

The term "dopant" as used herein is a trace of impurity element that is introduced under the manufacturing of silicon ingots to alter the resistivity of the silicon ingot.

The term deagglomerated as used herein refers to dry lumps of silicon kerf filtercake which has been subjected to a process where the lumps are disintegrated into smaller silicon kerf agglomerates and/or single particles of silicon kerf particles.

The term anode precursor material as used herein refers to a silicon powder material, which can be used as a) the active silicon material in a silicon-graphite composite material, or b) going into a coating process adapted for silicon with the intention to be used in LIBs, or c) the raw material for manufacturing of SiOₓ with the intention to be used in LIBs, or d) going into other processes with the intention to produce silicon based anode material.

### Brief description of the figures

Figure 1: Shows oxide layer thickness and uniformity as measured by scanning transmission electron microscopy and electron energy loss spectroscopy (STEM-EELS) characterization of silicon kerf anode/anode precursor product obtained by Process Route 1.
Figure 2: Shows oxide layer thickness and uniformity as measured by scanning transmission electron microscopy and electron energy loss spectroscopy (STEM-EELS) characterization of silicon kerf anode / anode precursor product obtained by Process Route 2.
Figure 3: Shows oxide layer thickness and uniformity as measured by X-ray Photoelectron Spectroscopy (XPS) of silicon kerf anode / anode precursor product obtained by Process Route 1.
Figure 4: Shows morphology of silicon kerf particles.
Figure 5: Show particle size distribution for silicon kerf single particles, deagglomerated silicon kerf, and crushed and sieved silicon kerf.
Figure 6: Shows initial capacity for silicon kerf particles obtained by Process Routes 1 and 2, compared to commercially available silicon anode materials.
Figure 7: Shows first cycle efficiency for silicon kerf particles obtained by Process Routes 1 and 2, compared to commercially available silicon anode materials.
Figure 8: Shows capacity as a function of cycle number for silicon kerf particles obtained by Process Routes 1 and 2, compared to commercially available silicon anode materials.
Figure 9: Shows the coulombic efficiency as a function of cycle number for silicon kerf particles obtained by Process Routes 1 and 2, compared to commercially available silicon anode materials.
Figure 10: Shows a block diagram of Process Route 1.
Figure 11: Shows a block diagram of Process Route 2.

### Detailed description of the invention

In a first aspect, the present invention provides silicon kerf particles having an oxide layer with a thickness of 0.2 to 4 nm, wherein the oxide layer is uniform around the whole of each individual particle with a maximum thickness variation of 1.0 nm.

In a preferred embodiment, the oxide layer on the silicon kerf particles has a thickness below 3 nm, e.g. from 0.2 to 2.9 nm, more preferably 0.5 to 2.5 nm, and most preferred 1-2 nm.

In another preferred embodiment, the oxide layer on the silicon kerf particles has a thickness variation around each individual particle of 0-1.0 nm, preferably 0-0.4 nm, more preferred 0-0.2 nm. Other preferable thickness variations are from 0.01 to 1.0 nm, preferably 0.01-0.4 nm, more preferred 0.01-0.2 nm.

In an embodiment, the silicon kerf particles further include from 10¹⁰ to 10²¹ atoms/cm³ of dopants selected from the group consisting of boron, phosphorus, antimony, gallium, aluminium, arsenic and combinations thereof.

In another embodiment, the d50 of the silicon kerf particles ranges from 10 nm to 4 µm, preferably from 50 nm to 2 µm, and more preferred from 100 nm to 1 µm.

The silicon kerf particles have a flake-like morphology, with narrow thickness of some tens nanometres, while the length of the particles can be up to 4 µm. The silicon kerf particles are typically partly amorphous and partly crystalline. This is common for most silicon kerf particles.

In a second aspect, the invention provides a powder comprising silicon kerf agglomerates and/or single particles of silicon kerf particles as defined above, wherein the tap density of the powder is from 0.05 to 0.8 g/cm³ and the agglomerate size range d10-d90 is from 0.05 to 10 µm. This means a narrow size distribution of the powder.

In a preferred embodiment, the tap density of the powder is from 0.05 to 0.5 g/cm³, and preferably 0.1 to 0.3 g/cm³.

In another preferred embodiment, the agglomerate size range of d10-d90 of the powder is between 0.1 and 8 µm, and preferably between 0.15 and 6 µm.

In a further embodiment, the carbon content of the powder ranges from 0.1 to 6 wt%, preferably from 0.3 to 3 wt%, and more preferred from 0.5 to 2 wt%.

In a third aspect, the present invention provides use of the silicon kerf particles and/or powder according to the invention, as anode material or anode precursor material in lithium-ion batteries.

In one embodiment of the invention, the anode material is mixed on slurry level with carbonaceous materials. The carbonaceous materials may be obtained from various sources, examples of which may include but not limited to petroleum pitches, lignins, coal tar pitches, petroleum cokes, flake coke, natural graphite, synthetic graphite, soft carbons, as well as other carbonaceous material that are known in the manufacture of electrodes, although these sources are not elucidated here.

The amount of silicon kerf particles and/or powder can range from 1- 90 wt% both in the anode material and in the anode precursor material in case of type a) according to the definition (i.e. used as the active silicon material in a silicon-graphite composite material).

The silicon kerf particles are prepared by conversion of silicon kerf filter cake material through several process steps into a dry, deagglomerated powder material where the primary particles are characterized by a thin, dense and uniform oxide layer, which is controlled through a drying process and a deagglomeration process based on jet milling, pin milling, ball milling or dry attrition milling, of which jet milling is preferred. This yields a very fluffy powder characterized by the tap density. A low tap density is indicative of a narrow size distribution and small agglomerate size.

Since single nanosized particles will result in a high first cycle loss due to the high surface area, and larger agglomerates pose issues with casting electrodes and cycling stability, this makes the deagglomerated kerf particles of the invention particularly suitable as a battery material as only smaller agglomerates are present.

An industrial scale batch process or continuous process has been developed for a controlled water removal and oxide layer engineering (drying process) of silicon kerf filter cake material.
- In a first step of this process, the filter cake material is either arranged in layers, inside a closed compartment or continuously moved through a reactor. In both cases the temperature is kept between 50 - 300 °C and the material is subjected to a continuous gas flow which contains from 2-30 vol% O₂ in N₂ or Ar.
- In a second step, the dried silicon kerf filter cake material obtained in the first step is subjected to industrial scale deagglomeration conducted in a fluidized-bed jet-mill under a flow of inert gas, N₂ or Ar, at a pressure of 3-6 Bar. The deagglomeration process is controlled by an air classifier run at a speed 500 - 3000 rpm.
- In a third optional step the dried and deagglomerated silicon kerf filter cake material obtained in the second step is subjected to heat treatment conducted at temperatures between 400-1000 °C and under an inert gas flow (N2 or Ar) or an oxidative gas flow (containing O2). This reduces the carbon contents from typically 0.1-6 wt% down to 0.3-3 wt%, typically 0.5-2 wt%.

The second and third steps can be carried out in reversed order.

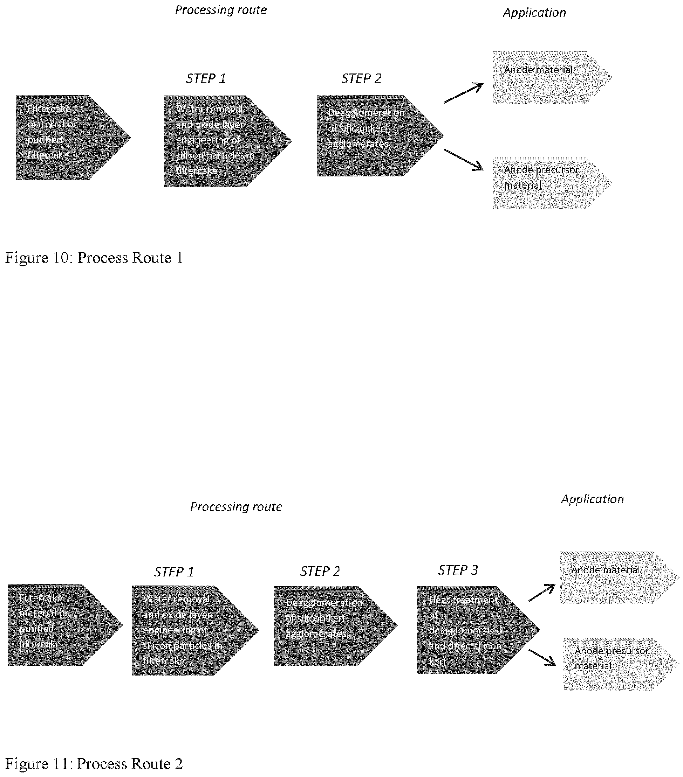

The process above is schematically illustrated in Figures 10 and 11. Figure 10 shows the process consisting of the first and second process steps, herein after named "Process Route 1" or "Route 1". Figure 11 shows the process consisting of the first, second and third process steps, herein after named "Process Route 2" or "Route 2".

Input kerf materials for Route 1 and Route 2 could, in addition to a silicon kerf filtercake, also be a purified silicon kerf. This purification is done by an acid treatment of the silicon kerf filter cake material in a slurry with water, followed by a filtration. Such a purified silicon kerf is characterized by a lower aluminium, nickel and carbon content, as can be seen in analyses in Table 1.

**Table 1: Chemical analyses of purified and non-purified silicon kerf filtercake**

| Element | Purified silicon kerf by acid treatment | Silicon kerf prior to purification |
|---|---|---|
| Al | 21 ppmw | 0.7 wt% (7000 ppmw) |
| Ni | 20 ppmw | 88 ppmw |
| Fe | 100 ppmw | 200 ppmw |

In Route 2, a post treatment step (third step), which is a heat treatment, is included. The silicon kerf will contain some impurities which come from the beam material and wire used during the wafering of the blocks. The silicon blocks are glued to a sacrificial beam prior to the wafering, the wires will penetrate into the sacrificial beam, and therefore the silicon kerf will contain some particles of the beam material and of the wire material. Particles from the wire material may also be present in the silicon kerf, typical elements are nickel, cobalt and copper. A common beam material is a composite of Al(OH)₃ and PMMA (polymethylmethacrylate). The heat treatment will decompose and remove the PMMA particles and therefore reduce the overall carbon contents in the silicon kerf, which is the goal of this additional step.

The kerf material processed according to Routes 1 and 2 has been tested as an anode material in mix with graphite (slurry level) in Li-ion batteries and shows comparable capacity and superior stability over time, when compared to conventional nanosized silicon materials for LIBs. The increased cycling stability is attributed both to the deagglomerated nature of the powder, the oxide layer on the particles and the morphology.

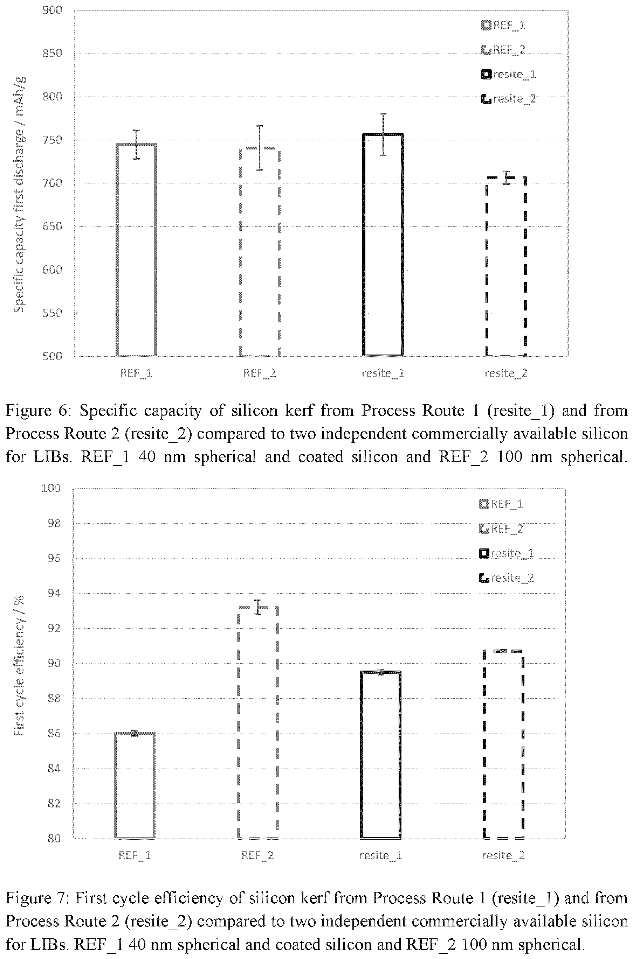

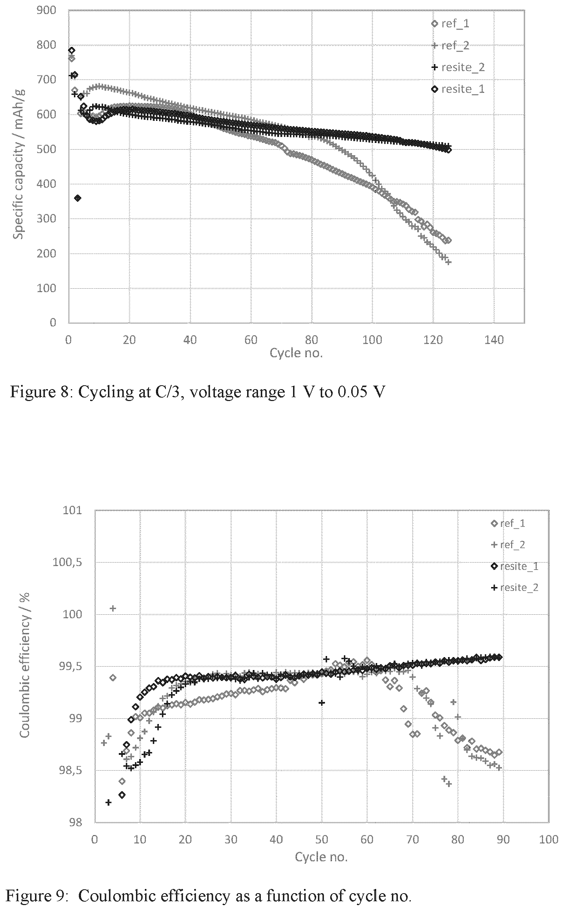

All the process steps to the anode material are low intensive in energy use and the material is a by-product from the photovoltaic industry. The lightly oxidized and deagglomerated silicon kerf of the invention as anode or anode precursor material to LIBs thus exhibit low carbon footprint and low costs which are clear improvements to current existing silicon anode materials on the market. In addition, the performance in terms of specific capacity and first cycle efficiency is on par with the commercially available silicon for LIBs (see Figures 6 and 7), and the cycling stability over time is superior (see Figures 8 and 9).

The silicon kerf material produced according to Routes 1 and 2 can be used directly as an anode material for LIBs in mix with graphite, but it can also be used as an anode precursor material. This means a silicon material that can: a) be the active silicon material in a silicon-graphite composite material, or b) go into a coating process adapted for silicon with the intention to be used in LIBs, or c) go in as the raw material for manufacturing of SiOₓ with the intention to be used in LIBs or d) go into other processes with the intention to produce silicon based anode material

The invention is explained in more detail in the examples below. The examples are only meant to be illustrative and shall not be considered as limiting.

### Example 1

Silicon kerf particles were prepared by conversion of silicon kerf filter cake material according to both Process Route 1 and Process Route 2.

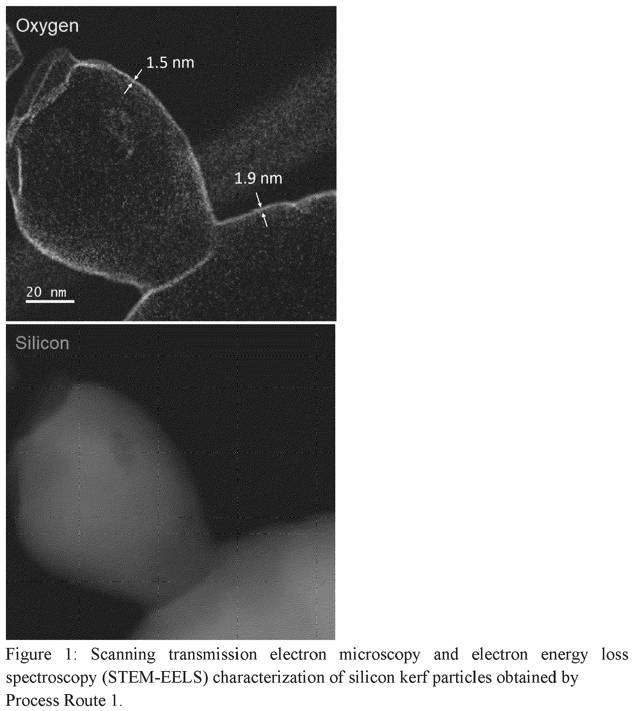

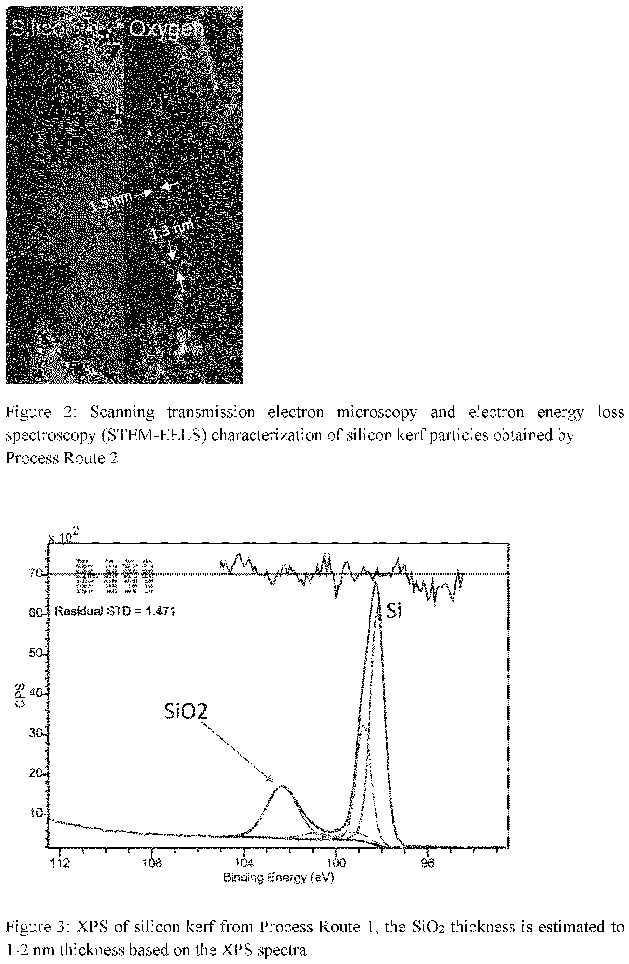

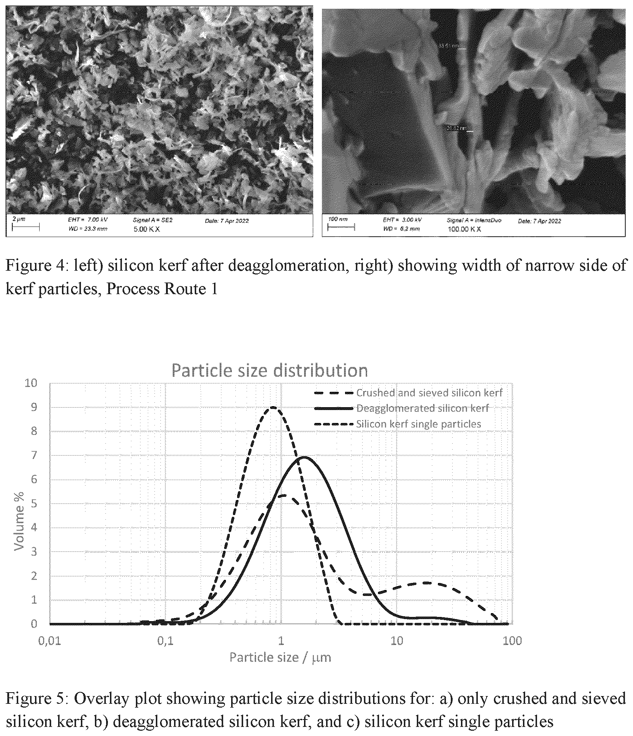

The oxide layer thickness and uniformity has been measured by scanning transmission electron microscopy with electron energy loss spectroscopy (STEM-EELS) and X-ray photoelectron spectroscopy (XPS), see Figures 1-3. In Figures 1 and 2, the oxide layer thickness from STEM-EELS is estimated to a thickness of 1-2 nm. In Figure 3, the curve with two main peaks at ~ 98 eV and -102 eV, is the real measurement data for the binding energy 93-112 eV. The other curves are the fitted curves and the background, where the peak at - 98 eV is fitted by two curves which both indicate Si 2p core electron in elemental silicon. The peak at - 102 eV is represented by one fitted curve which indicate Si 2p core electron in SiO₂. The oxide layer thickness is estimated to 1-2 nm from the XPS measurements, which correlates well with the STEM-EELS data. The particles are further characterized by a d50 - 700 nm as measured by laser diffraction. Furthermore, the particles have a unique flake like morphology, where the thinnest side is a few tens nanometres, see Figure 4.

### Example 2

The dried silicon kerf agglomerates were deagglomerated according to both Process Route 1 and Process Route 2.

A very fluffy powder characterized by a tap density measured to 0.15 g/cm³ was obtained. The majority of the agglomerates are between 0.6-4.7 µm as measured by laser diffraction. In comparison, a crushed silicon kerf sieved at 1 mm yields a tap density of 0.5 g/cm³. See Table 2 below. The particle size distribution (PSD) of single particles was obtained after a subjection to ultrasonic probe of the powder dispersed in water, length of ultrasonication was 30 minutes.

**Table 2: PSD analyses of kerf in different morphologies**

| Material | D10 | D50 | D90 |
|---|---|---|---|
| Deagglomerated silicon kerf by deagglomeration process described above | 0.6 | 1.7 | 4.7 |
| "Single kerf particles" obtained through long ultrasonication with ultrasonic probe in water (30 min) | 0.36 | 0.77 | 1.6 |
| Silicon kerf after crushing and sieving at 1 mm | 0.44 | 1.5 | 22.4 |

In Figure 5, the particle size distributions for: a) silicon kerf single particles of the invention, b) deagglomerated silicon kerf of the invention, and c) only crushed and sieved silicon kerf are shown in an overlay plot.

### Example 3

### Electrochemical testing:

All materials have been tested in half-cell configuration with lithium metal counter electrode, and active anode cast on dendritic copper foil.

The slurry composition was 12 wt% silicon kerf, 80 wt% synthetic battery grade graphite, 3 wt% CMC, 3 wt% SBR and 2 wt% carbon black (CB65). A cellgard 2000 separator was used, and the electrolyte was 1.2 M EC/EMC + 2% VC + 10% FEC. The formation cycling was run with 2xC/20 and 1xC/10, followed by cycling @ C/3, both with voltage range 1V to 50 mV.

The performance in terms of specific capacity and first cycle efficiency for the silicon kerf of the invention obtained by Process Routes 1 and 2 is on par with two tested commercially available silicon materials for LIBs (see Figures 6 and 7), and the cycling stability over time is superior (see Figures 8 and 9).

The person skilled in the art realizes that the present invention is not limited to the preferred embodiments described above. The person skilled in the art further realizes that modifications and variations are possible within the scope of the appended claims. Additionally, variations to the disclosed embodiments can be understood and effected by the skilled person in practicing the claimed invention, from a study of the disclosure, and the appended claims.

The projects leading to this patent application have received funding, from the European Union's Horizon 2020 research and innovation programme under grant agreements No 958365, No 641972, No 875568, from the Research Council of Norway (SkatteFUNN) and from EIT Raw Materials GmbH (Agreement no 17120).

## Claims

1. Silicon kerf particles having an oxide layer with a thickness of 0.2 to 4 nm, wherein the oxide layer is uniform around the whole of each individual particle with a maximum thickness variation of 1.0 nm.

2. The silicon kerf particles according to claim 1, wherein the thickness of the oxide layer is from 0.5 to 2.5 nm, preferably from 1 to 2 nm.

3. The silicon kerf particles according to claim 1 or 2, wherein the thickness variation around each individual particle is from of 0-1.0 nm, preferably 0-0.4 nm, and more preferred 0-0.2 nm.

4. The silicon kerf particles according to any one of the preceding claims, wherein the said particles include from 10¹⁰ to 10²¹ atoms/cm³ of dopants selected from the group consisting of boron, phosphorus, antimony, gallium, aluminium, arsenic and combinations thereof.

5. The silicon kerf particles according to any one of the preceding claims, wherein the d50 of the silicon kerf particles ranges from 10 nm to 4 µm, preferably from 50 nm to 2 µm, and more preferred from 100 nm to 1 µm.

6. A powder comprising silicon kerf agglomerates and/or single particles of silicon kerf particles as defined in any one claims 1 to 5, with a tap density of 0.05-0.8 g/cm³ and agglomerate size range of d10-d90 of 0.05-10 µm.

7. The powder according to claim 6, wherein the tap density is from 0.05 to 0.5 g/cm³, preferably 0.1 to 0.3 g/cm³.

8. The powder according to claim 6 or 7, wherein the agglomerate size range of d10-d90 is between 0.1 and 8 µm, preferably between 0.15 and 6 µm.

9. The powder according to any one of claims 6-8, having a carbon content ranging from 0.1 to 6 wt%, preferably from 0.3 to 3 wt%, and more preferred from 0.5 to 2 wt%.

10. Use of silicon kerf particles as defined in any one of claims 1 to 5 or a powder as defined in any one of claims 6 to 9, as anode material or anode precursor material in lithium-ion batteries.

11. Use according to claim 10 as anode material, wherein the anode material is mixed on slurry level with carbonaceous materials.

12. Use according to claim 11, wherein the anode material has an amount of silicon kerf particles and/or powder in the range of from 1- 90 wt%.

13. Use according to claim 10 as anode precursor material, wherein the anode precursor material is the active silicon material in a silicon-graphite composite material and has an amount of silicon kerf particles and/or powder in the range of from 1- 90 wt%.
